# FASCICULE DE BREVET EUROPEEN

(11) **EP 1 602 111 B1**
(45) Date de publication et mention de la délivrance du brevet: **11.07.2012**
(21) Numéro de dépôt: 04718678.8
(22) Date de dépôt: 09.03.2004
(51) Int. Cl.: G21G 1/10, H05H 6/00

(54) **SOURCE DE POSITONS**
POSITRONQUELLE
POSITRON SOURCE

(30) Priorité: 10.03.2003 FR 0302953; 15.05.2003 FR 0350154
(43) Date de publication de la demande: 07.12.2005
(73) Titulaire: Commissariat à l'Énergie Atomique et aux Énergies Alternatives, 75015 Paris (FR)
(72) Inventeur: PEREZ, Patrice, F-91440 BURES SUR YVETTE (FR); ROSOWSKY, André, F-75013 PARIS (FR)
(74) Mandataire: Poulin, Gérard
(86) Numéro de dépôt international: PCT/FR2004/050098
(87) Numéro de publication internationale: WO 2004/081951

(56) Documents cités:
- US-A- 5 107 221
- DECKER F -J: "Channeling crystals for positron production" 1991, NEW YORK, NY, USA, IEEE, USA, mai 1991 (1991-05), pages 2002-2004 vol., XP002260475 ISBN: 0-7803-0135-8
- INOUE M ET AL: "Experiment of positron generation using a crystal target at the KEK electron/positron linac" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, vol. 173, no. 1-2, janvier 2001 (2001-01), pages 104-111, XP004223560 ISSN: 0168-583X
- JORGENSEN L V ET AL: 'A positron accumulator for antihydrogen synthesis' MATER. SCI. FORUM (SWITZERLAND), MATERIALS SCIENCE FORUM, 2001, TRANS TECH PUBLICATIONS, SWITZERLAND vol. 363-365, 2001, pages 634 - 636, XP008023205 ISSN: 0255-5476
- GREAVES R G ET AL: "Positron trapping and the creation of high-quality trap-based positron beams" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, vol. 192, no. 1-2, mai 2002 (2002-05), pages 90-96, XP004361776 ISSN: 0168-583X cité dans la demande

## Description

### DOMAINE TECHNIQUE

La présente invention concerne une source de positons (« positrons »).

Elle a de très nombreuses applications, en particulier en physique de l'état solide, en science des matériaux et en physique des surfaces, où un haut taux de comptage (« counting rate ») est important pour beaucoup d'applications telles que, par exemple, le microscope à balayage à positons (« scanning positron microscope »), les mesures du temps de vie (« lifetime measurements ») en fonction de la profondeur d'implantation (« implantation depth ») ou de l'élargissement Doppler (« Doppler broadening »), et la PAES ou spectroscopie par électrons Auger induite par l'annihilation de positons (« positron annihilation induced Auger electron spectroscopy »).

D'autres applications de l'invention utilisent directement des « atomes » de positronium (le positronium étant l'état lié d'un électron et d'un positon). Or, la production de positronium nécessite, elle aussi, beaucoup de positons.

L'invention s'applique aussi en chimie moléculaire et plus particulièrement à la détermination de processus intervenant dans les matériaux supraconducteurs à haute température critique (« superconducting materials with high critical temperature »).

Elle s'applique également à la détermination de la capacité de vieillissement des peintures et des revêtements (« coatings »).

En outre, l'invention s'applique à la détection des défauts d'un matériau. on sait en effet que l'annihilation des positons est sensible à la densité des électrons. De petites variations de cette densité sont détectées, par exemple, lorsque le matériau se dilate thermiquement (« when the material thermally expands »). Des lacunes (vacancies »), c'est-à-dire des atomes uniques manquant dans le réseau (« single atoms missing from the lattice ») d'un matériau cristallin, sont alors détectées très facilement par leur faible densité électronique. Des concentrations de sites atomiques manquants, de l'ordre de 10⁻⁶, peuvent être observées (« concentrations of vacant atomic sites, on the order of 1ppm, are observable »).

Comme l'analyse d'un matériau par un faisceau de positons se fait sans contact, le matériau peut être chauffé à très haute température. Des sites vacants peuvent aussi être introduits à toute température par déformation mécanique, pulvérisation (« sputtering ») ou implantation d'ions.

L'énergie ajustable du faisceau de positons permet d'obtenir une information en profondeur, avec une résolution de 10%, pour des structures en couches minces ou des échantillons comportant une distribution de défauts non uniforme.

En outre, dans les oxydes de dispositifs microélectroniques tels que les MOS, des champs électriques peuvent être utilisés pour faire dériver les positons à l'interface d'étude.

Des groupements de sites vacants (« vacancy clusters »), formant des cavités de l'ordre de 0,5 nm, sont facilement observés par variation de l'élargissement Doppler et du temps de vie des positons.

L'observation de la formation de positronium permet de mettre en évidence la présence de cavités plus étendues et d'obtenir la taille de celles-ci (jusqu'à 20 nm).

Pour des cavités encore plus grandes, l'ortho-positronium (état du positon dans lequel les spins de l'électron et du positon sont anti-parallèles) survit suffisamment longtemps pour que sa désintégration en trois photons survienne. Dans ce cas, la corrélation angulaire des photons permet de gagner un facteur 5 sur l'élargissement Doppler.

Signalons encore d'autres applications de l'invention :
- la PRS ou spectroscopie par émission de positons (« positron reemission spectroscopy »),
- la PAES ou spectroscopie par électrons Auger, induite par l'annihilation de positons,
- la REPELS ou spectroscopie de la perte d'énergie des positons réémis (« re-emitted positron energy loss spectroscopy »),
- la LEPD ou diffraction de positons de basse énergie (« low-energy positron diffraction »),
- la PIIDS ou spectroscopie d'ions désorbés par des positons (« positron induced ion desorption spectroscopy »),
- la PALS ou spectroscopie par mesure du temps de vie des positons (« positron annihilation lifetime spectroscopy »), cette technique ayant une grande importance en microélectronique,
- la VEPLS ou spectroscopie par temps de vie de positons d'énergie variable (« variable energy positron lifetime spectroscopy »), et
- la PAS ou spectroscopie par annihilation de positons (« positron annihilation spectroscopy »).

La présente invention concerne plus particulièrement la production d'un faisceau de positons de basse énergie, inférieure à 10 MeV, ayant une intensité instantanée supérieure à 10¹⁰ positons par seconde, de préférence supérieure à 10¹² positons par seconde, en vue d'obtenir, par exemple :
- un faisceau de positons de faible énergie, dont l'énergie est inférieure à 10 keV, par couplage avec un piège (« trap ») approprié, ou
- des atomes de positronium, par interaction avec une cible appropriée.

### ETAT DE LA TECHNIQUE ANTERIEURE

La production à haut débit (supérieur à 10¹⁰ par seconde) de positons de faible énergie et « d'atomes » de positronium est nécessaire pour les applications industrielles telles que les mesures de défauts dans les cristaux ou les matières organiques, lorsque l'on utilise, par exemple, la PAS (spectroscopie par annihilation de positons) ou d'autres méthodes mentionnées plus haut.

Ces applications utilisent principalement des sources de ²²Na en tant que sources de faisceau de positons. De telles sources compactes se prêtent bien à la recherche en laboratoire. Mais leur activité (« activity ») maximale se situe autour de 4x10⁹ Bq et leur vie moyenne (« lifetime ») est de seulement 2,6 ans.

Il existe, par ailleurs, quelques accélérateurs dont une partie de l'activité, souvent mineure, se porte sur la production de faisceaux de positons. Cependant, il s'agit d'installations « lourdes » puisque, bien souvent, l'énergie des électrons utilisés est de plusieurs dizaines de MeV, typiquement 100 MeV. Les positons émis peuvent atteindre plusieurs dizaines de MeV (voir par exemple F.J. Decker "Channeling Crystals for Position Production", 1991, IEEE Particle Accelerator Conference, vol. 3, pages 2002-2004) .

De plus, les positons utiles pour les applications industrielles ont une énergie cinétique (« kinetic energy ») inférieure à au moins mille fois l'énergie du seuil de production (« production threshold »). Pour les ralentir, on utilise classiquement des modérateurs (« moderators ») métalliques de très faible efficacité (inférieure à 0,001).

D'autre part, on sait piéger un faisceau de positons dans un dispositif appelé « piège de Penning-Malmberg ». Un piège (« trap ») amélioré, appelé « piège de Greaves-Surko », permet d'augmenter énormément la brillance (« brightness ») du faisceau en divisant par mille la dispersion en énergie de ce faisceau, avec une efficacité de l'ordre de 1.

Des pièges de Greaves-Surko sont commercialement disponibles auprès de la Société First Point Scientific. Ils comportent un modérateur en néon solide, dont l'efficacité est voisine de 1%.

Depuis l'apparition de tel pièges, très avantageux pour les applications sus-mentionnées, leur utilisation se généralise mais exige que les positons aient une énergie inférieure à 1 MeV.

De plus, on connaît quatre techniques pour produire des positons. Ces techniques utilisent des sources radioactives (de type ²²Na) ou les flux de neutrons de réacteurs nucléaires ou des accélérateurs en tandem (destinés à accélérer des ions) ou des accélérateurs d'électrons.

On examine ci-après les inconvénients de ces techniques.

Le courant de positons fourni par une source radioactive est limité par l'épaisseur du matériau qui enveloppe la source. De plus, l'intensité du faisceau de positons émis par une telle source est de l'ordre de 10⁸e⁺/s et donc de l'ordre de 10⁶e⁺/s après modération.

L'utilisation des flux de neutrons sortant d'un réacteur nucléaire permet d'obtenir des sources radioactives à courte durée de vie, aptes à produire des positons de faible énergie. Cependant, une telle technique n'est pas industrialisable car elle nécessite un réacteur nucléaire.

Une variante de la technique précédente consiste à utiliser un accélérateur en tandem (« tandem accelerator ») pour accélérer des ions qui sont envoyés sur une cible. Cette cible devient radioactive et émet des positons de faible énergie. Bien qu'un accélérateur en tandem soit plus petit qu'un accélérateur de particules classique, il constitue une installation lourde qui nécessite une protection contre l'activation et une infrastructure de maintenance.

De grands accélérateurs linéaires, plus simplements appelés « linacs », sont également utilisés pour produire des positons, en accélérant des électrons et en envoyant ces derniers sur une cible de tungstène ou de tantale (« tantalum »). Cependant, ces grands linacs sont des installations trop « lourdes » et trop peu nombreuses pour être propices au développement des applications des positons, du genre de celles qui ont été mentionnées plus haut.

Revenons sur les chambres d'interaction connues, contenant une cible qui est apte à engendrer des positons par interaction avec un faisceau d'électrons.

Pour produire des positons (notés e⁺) à partir d'un faisceau d'électrons (notés e⁻), on doit faire interagir ces électrons avec un matériau-cible. Les électrons émettent alors des photons X et gamma, lesquels se désintègrent parfois en paire (e⁺ e⁻).

Comme le nombre de positons produits dépend du nombre d'électrons ayant interagi avec le matériau-cible, l'homme du métier est conduit à utiliser des faisceaux intenses comme ceux produits par des accélérateurs de type linac.

Comme le nombre de e⁺ produits par un faisceau d'électrons croît avec l'épaisseur de cible traversée, l'homme du métier est conduit à augmenter cette épaisseur.

Mais alors deux problèmes se posent.

Premièrement, les rayons X déposent de l'énergie sous forme de chaleur dans la cible.

Deuxièmement, les e⁺ créés peuvent être capturés dans la cible et s'annihiler avant de sortir de celle-ci. Cette annihilation peut avoir lieu suivant deux réactions, à savoir la collision directe avec un électron ou la formation d'un atome de positronium.

L'homme du métier associe naturellement l'usage d'une cible épaisse avec l'utilisation d'accélérateurs ayant une énergie élevée.

Les systèmes qui produisent des e⁺ de haute énergie (supérieure à 10 MeV) pour des expériences de physique des particules sont moins sensibles au deuxième problème parce que les e⁺ de haute énergie ne s'annihilent pas, et en particulier ne forment pas de positronium. Par contre, pour les applications industrielles, où les e⁺ doivent avoir une très faible énergie, la formation de positronium durant le trajet qui sépare le lieu de création d'un e⁺ du point de sortie de la cible détruit une grande partie des e⁺.

En revanche, le premier problème devient très pénalisant aux hautes énergies. Pour une même chaleur déposée dans la cible, un générateur de faisceau d'électrons de 100 MeV et un générateur de faisceau d'électrons de 10 MeV fourniront la même quantité de positons « utiles », d'énergie inférieure ou égale à 1 MeV.

A titre d'exemple, considérons d'une part la technique existante d'un générateur de 100 MeV envoyant des électrons sur une cible de 1mm x 1 cm² à 90 degrés, et d'autre part un générateur de 10 MeV envoyant des électrons sur une cible de 50 µm x 1 cm² à 3 degrés comme proposé selon un exemple de la présente invention. Pour une même chaleur déposée dans la cible, et un nombre similaire de e+ utiles produits, le générateur de 100 MeV consommera 50 kW et celui de 10 MeV consommera 10 kW. Les 40 kW de différence sont gaspillés et doivent être évacués du système dé collection sous forme de chaleur.

Pour utiliser une plus grande proportion des positons produits, les grandes installations utilisant un linac de haute énergie comme le Lawrence Livermore National Laboratory, en Californie (USA), ainsi que l'ISA « Institut for Storage ring facilities, University of Aarhus » (Danemark), recourrent à des feuilles de ralentissement en tungstène, placées après la cible, éventuellement combinées à un champ électrique approprié. Mais un tel dispositif absorbe beaucoup de positons, c'est à dire limite l'intensité du faisceau.

### EXPOSÉ DE L'INVENTION

La présente invention a pour but de remédier aux inconvénients précédents.

Elle a pour objet une source de positons, cette source comprenant des moyens de génération d'un faisceau d'électrons et une cible qui comporte une surface sensiblement plane, cette cible étant prévue pour recevoir, sur cette surface sensiblement plane, le faisceau d'électrons sous un angle d'incidence prédéfini, compté par rapport à la surface sensiblement plane, et pour engendrer les positons par interaction avec ce faisceau d'électrons, cette source étant caractérisée en ce que le faisceau d'électrons généré est continu ou quasi-continu et les électrons ont une énergie de l'ordre de 10 MeV, et l'épaisseur de la cible est inférieure à 500 µm et l'angle d'incidence prédéfini est inférieur à 10°.

Selon un mode de réalisation préféré de la source de positons objet de l'invention, l'épaisseur de la cible est comprise dans l'intervalle allant de 10 µm à 100 µm, préférentiellement autour de 50 µm, et l'angle d'incidence prédéfini est compris dans l'intervalle allant de 2° à 5°.

De préférence, les moyens de génération du faisceau d'électrons génèrent un faisceau continu et comprennent un accélérateur d'électrons comportant une cavité coaxiale que les électrons traversent plusieurs fois dans un plan médian, perpendiculaire à l'axe de cette cavité.

Cet accélérateur d'électrons est connu sous le nom de « Rhodotron » (marque déposée) et décrit dans le document suivant :
FR 2616032 A correspondant à US 5107221 A.

Selon un mode de réalisation préféré, la présente invention comporte en outre des moyens de triage entre les positons et les électrons n'ayant pas interagi avec la cible, qui comprennent :
- des premiers moyens magnétiques dont l'axe est voisin de celui du faisceau et passe par le plan de cible, prévus pour engendrer un champ magnétique apte à faire diverger les positons émis par la cible, ces premiers moyens magnétiques étant disposés en amont de la cible à une distance appropriée,
- un quadrupôle magnétique de focalisation du faisceau de positons, de même axe que les premiers moyens magnétiques, disposé en aval de la cible, et destiné à rendre circulaire la section du faisceau de positons, qui est très aplatie à la sortie de la zone d'interaction entre les électrons et la cible,
- des premiers moyens d'arrêt, situés sur l'axe des premiers moyens magnétiques, en aval du quadrupôle, à une distance suffisante pour la focalisation des positons en un faisceau de section circulaire, prévus pour arrêter des électrons du faisceau d'électrons qui n'ont pas interagi avec la cible
- des deuxièmes moyens magnétiques, de même axe que les premiers moyens magnétiques, disposés en aval des premiers moyens d'arrêt, et à une distance appropriée des premiers moyens magnétiques pour engendrer un champ magnétique apte à faire converger les positons, les premiers et deuxièmes moyens coopérant pour engendrer un champ magnétique apte à éviter à ces positons de rencontrer les premiers moyens d'arrêt.

La source de positons objet de l'invention peut comprendre en outre des moyens de piégeage (« trapping means »), prévus pour piéger les positons engendrés par la cible.

Les moyens de piégeage comportent un modérateur prévu pour ralentir les positons et des moyens électro-magnétiques de concentration de ces positons.

Ces moyens de piégeage peuvent comprendre un piège (« trap ») de Greaves-Surko au sujet duquel on consultera le document suivant :
R. Greaves et C. M. Surko, Nucl. Inst. Meth. B192 (2002) 90.

De préférence la source de positons objet de l'invention comprend en outre :
- des deuxièmes moyens d'arrêt, comme par exemple un mur de plomb refroidi par circulation d'eau, prévus pour arrêter des électrons du faisceau d'électrons, qui n'ont pas interagi avec la cible et ont atteint une zone comprise entre les deuxièmes moyens magnétiques et les moyens de piégeage, et pour empêcher ces électrons d'atteindre ces moyens de piégeage, et
- des moyens de guidage des positons vers les moyens de piégeage à travers ces deuxièmes moyens d'arrêt.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés, sur lesquels :
- les figures 1A et 1B sont des vues schématiques d'un mode de réalisation particulier de la source de positons objet de l'invention, et
- la figure 2 est une vue en coupe schématique de la cible utilisée dans la source de positons de la figure 1.

### EXPOSÉ DÉTAILLÉ DE MODES DE RÉALISATION PARTICULIER

L'invention repose essentiellement sur l'interaction d'une cible mince, de préférence en tungstène, et d'un faisceau d'électrons que l'on envoie sous incidence rasante sur cette cible.

De préférence, l'épaisseur de la cible est comprise dans l'intervalle allant de 10µm à 100µm et vaut par exemple 50µm et l'angle du faisceau d'électrons avec la cible est compris dans l'intervalle allant de 2° à 5° et vaut par exemple 3°.

Cette invention permet de produire des positons ayant une basse énergie (inférieure à 1 MeV) à partir de faisceaux d'électrons de faible énergie (10 MeV), émis par une source d'électrons fonctionnant en mode continu. Grâce à cette caractéristique, la source d'électrons peut être un Rhodotron (marque déposée), qui est une machine industrielle, de faible volume et de faible consommation (100kW au maximum).

Les deux problèmes mentionnés plus haut limitent la capacité de production de positons de basse énergie dans les systèmes connus. L'invention repousse ces limites en abaissant la chaleur déposée dans la cible. Enfin, l'invention permet une collection plus efficace des e⁺ produits.

Schématiquement, dans les systèmes connus, les e⁻ sont envoyés à 90° (ou à grand angle, par exemple 45°) du plan de la cible. Dans l'invention, les e⁻ sont envoyés avec une incidence rasante, typiquement 3°, par rapport au plan de la cible. Cette configuration particulière présente plusieurs avantages par rapport aux configurations des systèmes connus.

Les inventeurs ont observé que pour un même nombre d'électrons traversant la cible l'échauffement est 2,5 fois plus petit à 3°, qu'à épaisseur (distance) équivalente égale , on ne produit pas moins de e⁺ de faible énergie en étant à 3° et qu'à échauffement égal on produit environ le double de e⁺ à 3°.

Considérons ensuite l'efficacité de collection des e⁺ produits.

Une fois les e⁺ produits et extraits de la cible, il faut les séparer du faisceau d'électrons car celui-ci a une énergie très grande, incompatible avec les appareillages qui collectent les e⁺.

Par ailleurs, pour utiliser les e⁺, il faut pouvoir les concentrer spatialement. Ces deux contraintes sur l'utilisation des e⁺ sont réalisées dans les systèmes connus au prix d'une très grande perte de e⁺.

A nouveau, l'utilisation d'un faisceau en incidence rasante (par exemple 3°) sur une cible mince, dont l'épaisseur vaut par exemple 50µm (épaisseur équivalente : 1 millimètre), permet d'obtenir une bonne efficacité de collection des e⁺ tout en les séparant des e⁻.

En effet, en incidence rasante on peut étaler les e⁻ sur une grande surface de cible sans pour autant que les e⁺ produits soient collectés sur une grande surface. Appelons "surface frontale" la surface d'où viennent les e⁺ vus depuis le système de collection.

Alors, à 3°, la surface frontale d'interaction des e⁻ sur la cible est de 1x20 mm² pour une surface de cible de 20x20 mm². A une incidence de 90°, cette surface frontale serait 20 fois plus grande Donc le système de collection devrait couvrir une surface 20 fois plus grande.

Dans la configuration en incidence rasante, la corrélation statistique entre l'angle d'émission d'un positon et l'énergie de ce dernier est conservée.

En particulier, comme les e⁺ de basse énergie que l'on souhaite collecter sont émis à grand angle par rapport aux électrons; cette séparation angulaire peut être mise à contribution pour séparer les e⁺ des e⁻ du faisceau qui traverse la cible.

Ces deux avantages vont maintenant être présentés à propos d'un exemple de la source de positons, objet de l'invention.

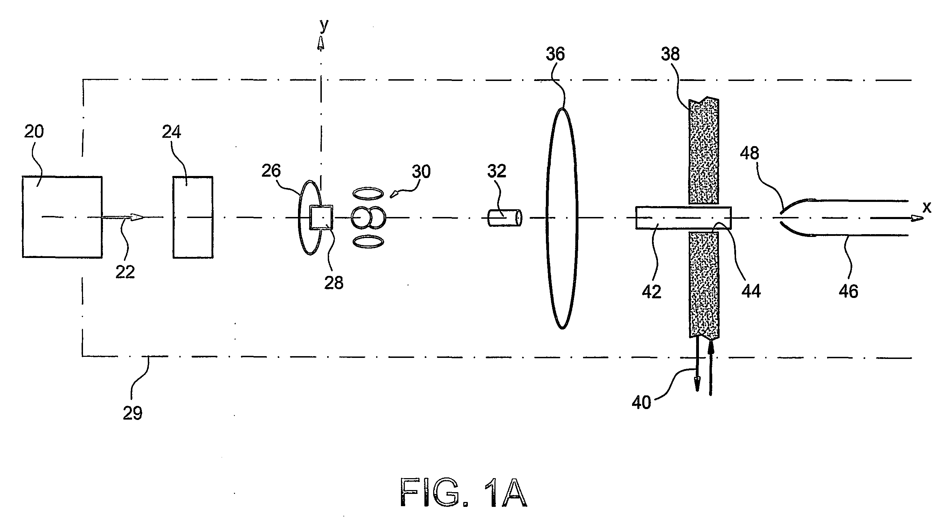

Cet exemple est schématiquement représenté sur la figure 1A et constitue un système de production et d'extraction de e⁺ de basse énergie (inférieure ou égale à 1 MeV).

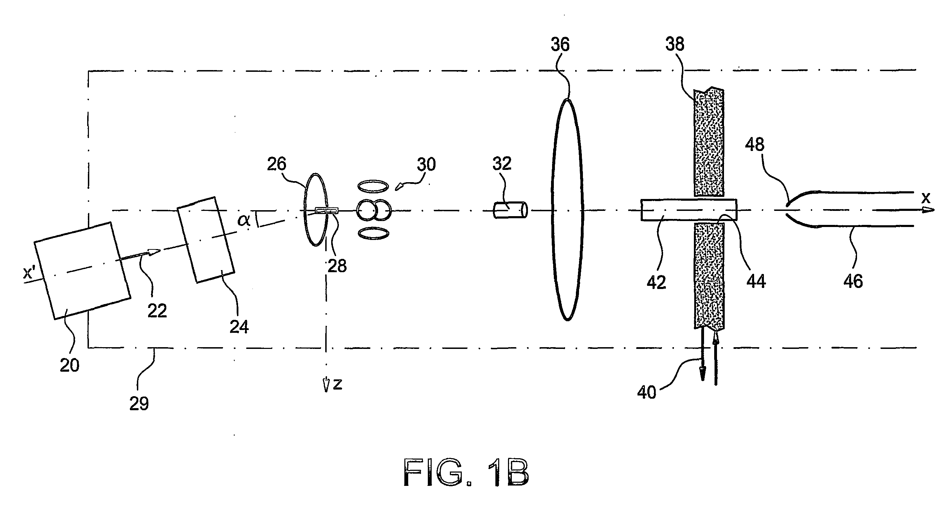

Ce système comprend successivement, le long d'un axe x :
- un Rhodotron (marque déposée) 20, qui fournit un faisceau d'électrons 22 destiné à produire les positons, ce faisceau se propageant suivant l'axe x' (figures 1A et B) à 3 degrés de l'axe x,
- des moyens 24 de mise en forme et de guidage du faisceau 22,
- une première bobine magnétique 26, dont l'axe est l'axe x,
- une plaque mince 28 en tungstène, dont une face reçoit le faisceau 22 sous une incidence rasante, cette plaque 28 constituant la cible pour les électrons,
- un aimant quadrupolaire 30 qui focalise sur l'axe x les positons émis par la plaque 28,
- un cylindre 32 en tungstène, destiné à arrêter des électrons ayant traversé la plaque 28,
- une deuxième bobine magnétique 36, dont l'axe est l'axe x,
- un mur en plomb 38, destiné à absorber les électrons résiduels et refroidi par une circulation d'eau 40,
- un solénoïde 42 dont l'axe est l'axe x et qui traverse le mur 38, un perçage 44 étant prévu à cet effet dans le mur, ce solénoïde pouvant être remplacé par un ensemble de bobines magnétiques admettant l'axe x comme axe commun,
- un piège de Greaves-Surko 46 précédé d'un modérateur 48.

Une enceinte à vide 29 est prévue pour la propagation sous vide des électrons, issus du Rhodotron, et des positons.

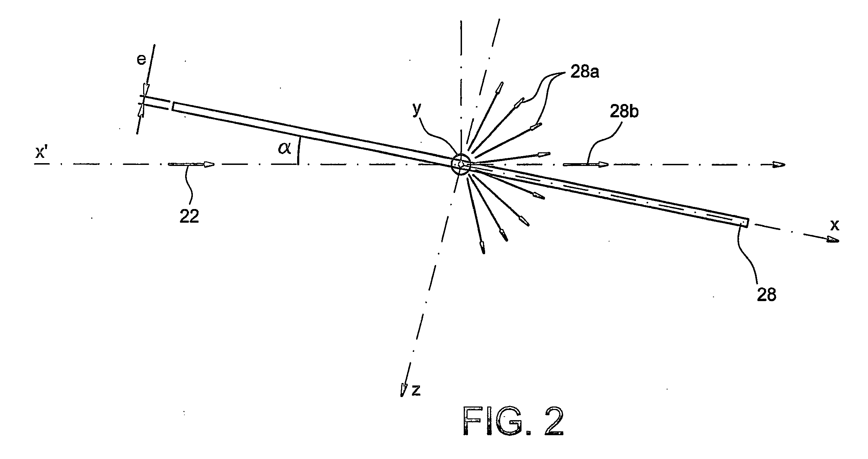

La figure 2 permet de préciser l'orientation de la plaque-cible 28 dont l'épaisseur est notée e.

On définit deux autres axes y et z perpendiculaires l'un à l'autre et à l'axe x, comme on le voit sur les figures 1A et 2. Sur la figure 1B, l'exemple de la figure 1A est vu de dessus (suivant l'axe y).

La plaque 28 est dans le plan xy. Le faisceau d'électrons se propage suivant un angle alpha très faible, de l'ordre de 3 degrés dans l'exemple, par rapport à la plaque 28.

On voit aussi des flèches 28a représentant les positons émis par la cible et une flèche 28b représentant les électrons qui traversent cette cible, sans interagir avec celle-ci.

La bobine 26 a un diamètre intérieur de 20 cm. Elle est parcourue par un courant de 800 kA. Cette bobine produit en son centre un champ magnétique de 5,06 T, et peut avantageusement être supraconductrice.

La cible en tungstène a une épaisseur e de 50µm. Elle est placée à une vingtaine de centimètres après le centre de la bobine 26 et sa surface est de 3 cm x 3 cm, bien que seule une partie centrale de 2 cm x 2 cm de cette surface intercepte les électrons. L'aimant quadrupolaire 30 comporte quatre bobines constituant les pôles de cet aimant et ayant une surface d'entrée située à 20 cm de l'axe x. Ces bobines ont 100 boucles et chaque boucle est parcourue par un courant de 20 A. L'aimant 30 est placé à une distance de 10 cm du bord de la cible 28.

La bobine 36 a un de diamètre intérieur de 100 cm. Cette bobine a 1000 boucles et chaque boucle est parcourue par un courant de 20 A. Cette bobine est placée à une distance de 90 cm du centre de la cible 28.

Le solénoïde 42 a un diamètre légèrement inférieur à 10 cm et une longueur de 100 cm et peut être remplacé par des bobines de diamètre légèrement inférieur à 10 cm, espacées de 7 cm les unes des autres. Ces bobines ont chacune 100 boucles et sont chacune parcourues par un courant de 20 A.

Que ce soit avec un solénoïde ou avec des bobines, il s'agit de réaliser un tube de champ magnétique assez uniforme et de faible intensité qu'on appelle "tube de sortie".

Ce tube de sortie traverse dans ses derniers 10 cm le mur de plomb 38 qui sert à absorber les e- tandis que les e+ collectés traversent le mur à travers le tube de sortie.

Le faisceau d'électrons 22, de 10 MeV, fourni par le Rhodotron, est rectangulaire, avec une section de 1 mm x 20 mm, la plus grande dimension (20 mm) étant parallèle au plan de la cible. la trajectoire du faisceau fait un angle de 3° par rapport à ce plan.

La cible est placée après la bobine supraconductrice 26 pour que les e+ émis par la cible soient dans un champ divergent. Cette configuration permet aux e⁺ de très basse énergie (quelques dizaines de keV) de se propager vers les x positifs ("vers l'avant").

Les e+ de moins de 1 MeV étant émis préférentiellement à un angle supérieur a 45°, ils sont capturés par les lignes de champ de la bobine 26 et divergent par rapport à l'axe x. La bobine 36, dont le diamètre est 3 fois plus grand que celui de la bobine 26 et dont le courant est 30 fois plus faible que celui de cette bobine 26, produit un champ faiblement convergent.

Cette bobine 36 étant placée à 1,10 mètre de la bobine 26, elle ne devient prépondérante qu'à 80 cm de la cible de sorte que les e+ de basse énergie qui s'étaient éloignés de l'axe x en suivant les lignes de champ de la bobine 26 sont maintenant captés par celles de la bobine 36 et convergent à nouveau vers l'axe x.

Ce trajet, qui s'éloigne puis se rapproche de l'axe x, permet aux e+ de basse énergie d'éviter le cylindre de tungstène 32, ce cylindre 32 ayant un diamètre de 2 cm et une longueur de 5 cm et se trouvant sur l'axe x à 50 cm de la cible.

Les électrons qui n'ont pas produit de paire (e+e-) ont une énergie comprise entre 9 MeV et 10 MeV. ils ne sont donc pas piégés par les lignes de champ des bobines 26 et 36. Ces électrons, dont la trajectoire avant la cible est à 3° de l'axe x, restent sensiblement dans un cône d'axe x et de demi-angle au sommet 3°.

La bobine 26 fait en outre tourner le faisceau d'électrons de 45° environ autour de l'axe x tout en restant sensiblement dans ce cône, ce dont il faudra tenir compte pour choisir l'orientation de la cible. En conséquence, ces électrons s'éloignent de 5 cm environ pour 1 mètre de propagation suivant l'axe x.

Du fait de la forme rectangulaire du faisceau, 10 % de ces électrons se mélangeraient aux e+ à la sortie du système si l'on ne les arrêtait pas. Mais, comme la bobine 26 ne les éloigne pas de l'axe x, ces électrons sont arrêtés par le cylindre de tungstène.

Après la bobine 36, les e⁺ sont guidés vers la sortie par le tube de champ magnétique (ce champ étant faible). La distance qui sépare la bobine 36 du mur de sortie 38 est de 1 mètre.

Les électrons qui n'ont pas été arrêtés par le cylindre de tungstène 32 sont, au niveau du mur de sortie 38, en dehors de ce cylindre 32 de sorte qu'ils sont arrêtés par ce mur qui est constitué d'un blindage en plomb refroidi par une circulation d'eau.

L'efficacité du système de la figure 1A est illustrée par les valeurs numériques suivantes.

Un faisceau d'électrons ayant une énergie de 10 MeV et une intensité de 5 mA, a une puissance de 50 kW. Sur ces 50 kW :
○ la cible produit environ 10 W sous forme de paires (e+e-),
○ 5 kW sont arrêtés par le cylindre en tungstène,
○ 100 W passent à travers le tube de sortie, à un rayon inférieur à 4cm,
○ 350 W passent à travers le tube de sortie, à une distance comprise entre 4 cm et 5 cm de l'axe x,
○ le reste (environ 44,5 kW) est arrêté par le mur de plomb.

Par ailleurs, l'efficacité de collection, mesurée comme étant le nombre de e+ à la sortie du tube de sortie, divisée par le nombre de e+ produit, est respectivement de 55 % environ pour des e+ de moins de 1 MeV et de 60 % environ pour des e+ de moins de 600 keV.

Ce système illustre l'intérêt d'une cible mince (par exemple de 50µm d'épaisseur), utilisée en incidence rasante, car cela permet de garder la corrélation entre l'angle d'émission des e⁺ et l'énergie. Sans cette corrélation, la séparation ne fonctionnerait pas.

Par ailleurs, cette configuration permet de garder une petite section de faisceau (1 mm x 20 mm) sans laquelle les e⁺ émis seraient trop dispersés pour pouvoir être collectés efficacement à la sortie.

L'ensemble du trajet des positons se trouve dans une enceinte à vide dans laquelle la pression résiduelle est faible, de préférence inférieure à 100 Pa. En effet, à la pression atmosphérique (de l'ordre de 10⁵Pa), 65 % des e⁺ seraient perdus (ce calcul tenant compte de la diffusion (« scattering »)). Une pression de l'ordre de 10²Pa réduit la perte à moins de un pour mille.

## Revendications

1. Source de positons, cette source comprenant des moyens (20) de génération d'un faisceau d'électrons, et une cible (28) qui comporte une surface sensiblement plane, cette cible étant prévue pour recevoir, sur cette surface sensiblement plane, un faisceau d'électrons sous un angle d'incidence prédéfini, compté par rapport à la surface sensiblement plane, et pour engendrer les positons par interaction avec ce faisceau d'électrons, cette source étant **caractérisée en ce que** le faisceau d'électrons généré est continu ou quasi-continu et les électrons ont une énergie de l'ordre de 10 MeV, et l'épaisseur de la cible est inférieure à 500 µm et l'angle d'incidence prédéfini est inférieur à 10°.

2. Source de positons selon la revendication 1, dans laquelle l'épaisseur de la cible (28) est comprise dans l'intervalle allant de 10 µm à 100 µm et l'angle d'incidence prédéfini est compris dans l'intervalle allant de 2° à 5°.

3. Source de positons selon l'une quelconque des revendications 1 et 2, dans laquelle les moyens de génération du faisceau d'électrons génèrent un faisceau continu, et comprennent un accélérateur d'électrons (20) comportant une cavité coaxiale que les électrons traversent plusieurs fois dans un plan médian, perpendiculaire à l'axe de cette cavité.

4. Source de positons selon l'une quelconque des revendications 1 à 3, comportant en outre des moyens de triage entre les positons et les électrons n'ayant pas interagi avec la cible, qui comprennent :
- des premiers moyens magnétiques (26) dont l'axe est voisin de celui du faisceau et passe par le plan de la cible, prévus pour engendrer un champ magnétique apte à faire diverger les positons émis par la cible, ces premiers moyens magnétiques étant disposés en amont de la cible à une distance appropriée,
- un quadrupôle magnétique (30) de focalisation du faisceau de positons, de même axe que les premiers moyens magnétiques, disposé en aval de la cible, et destiné à rendre circulaire la section du faisceau de positons, qui est très aplatie à la sortie de la zone d'interaction entre les électrons et la cible ,
- des premiers moyens d'arrêt (32), situés sur l'axe des premiers moyens magnétiques, en aval du quadrupôle, à une distance suffisante pour la focalisation des positons en un faisceau de section circulaire, prévus pour arrêter des électrons du faisceau d'électrons qui n'ont pas interagi avec la cible,
- des deuxièmes moyens magnétiques (36), de même axe que les premiers moyens magnétiques, disposés en aval des premiers moyens d'arrêt, et à une distance appropriée des premiers moyens magnétiques pour engendrer un champ magnétique apte à faire converger les positons, les premiers et deuxièmes moyens coopérant pour engendrer un champ magnétique apte à éviter à ces positons de rencontrer les premiers moyens d'arrêt.

5. Source de positons selon l'une quelconque des revendications 1 à 4, comportant en outre :
- des moyens de piégeage (46), prévus pour piéger les positons engendrés par la cible, et
- des moyens de guidage (42), prévus pour guider ces positons vers ces moyens de piégeage.

6. Source de positons selon la revendication 5, dans laquelle les moyens de piégeage (46) comprennent un piège de Greaves-Surko.

7. Source de positons selon la revendication 4 et l'une quelconque des revendications 5 et 6, comprenant en outre :
- des deuxièmes moyens d'arrêt (38), prévus pour arrêter des électrons du faisceau d'électrons, qui n'ont pas interagi avec la cible et ont atteint une zone comprise entre les deuxièmes moyens magnétiques et les moyens de piégeage, et pour empêcher ces électrons d'atteindre ces moyens de piégeage, et
- des moyens de guidage (42) aptes à guider les positons vers les moyens de piégeage, à travers ces deuxièmes moyens d'arrêt.

## Claims

1. positron source, this source comprising means (20) of generating an electron beam and a target (28) that comprises a substantially plane surface, this target being designed to receive an electron beam on this substantially plane surface, at a predetermined angle of incidence, counted with respect to the substantially plane surface, and to generate positrons by interaction with this electron beam, this source being **characterized in that** the generated electron beam is continuous or quasi-continuous and the energy of the electrons is of the order of 10 MeV, and the target thickness is less than 500 µm and the predetermined angle of incidence is less than 10°.

2. Positron source according to claim 1, in which the thickness of the target (28) is within the interval ranging from 10 µm to 100 µm and the predetermined angle of incidence is within the interval ranging from 2° to 5°.

3. Positron source according to either of claims 1 and 2, in which the electron beam generation means generate a continuous beam and comprise an electron accelerator (20) comprising a coaxial cavity that electrons pass through several times in a median plane perpendicular to the axis of this cavity.

4. Positron source according to any one of claims 1 to 3, also comprising sorting means between positrons and electrons that did not interact with the target, said sorting means comprising:
- first magnetic means (26), whose axis is close to the beam axis and passes through the plane of the target, and which are designed to generate a magnetic field that can make positrons emitted by the target diverge, these first magnetic means being arranged upstream of the target at an appropriate distance,
- a magnetic quadrupole (30) for focusing the positron beam, said magnetic quadrupole having the same axis as the first magnetic means, being placed downstream of the target, and being designed to make the positron beam section circular, said positron beam being very flat at the output from the area of the interaction between electrons and the target,
- first stop means (32), located on the axis of the first magnetic means, downstream of the quadrupole, at a sufficiently long distance to focus positrons into a beam with a circular section, said first stop means being designed to stop electrons from the electron beam that did not interact with the target,
- second magnetic means (36), along the same axis as the first magnetic means, arranged downstream of the first stop means, at an appropriate distance from the first magnetic means to generate a magnetic field capable of making the positrons converge, the first and second means cooperating to generate a magnetic field capable of preventing these positrons from encountering the first stop means.

5. Positron source according to any one of claims 1 to 4, also comprising:
- trapping means (46) designed to trap positrons generated by the target,
- guiding means (42) designed to guide these positrons towards these trapping means.

6. Positron source according to claim 5, in which the trapping means (46) include a Greaves-Surko trap.

7. Positron source according to claim 4 and any of claims 5 and 6, also comprising:
- second stop means (38), designed to stop electrons in the electron beam which did not interact with the target and which reached a zone between the second magnetic means and the trapping means, and to prevent these electrons from reaching these trapping means, and
- guiding means (42) capable of guiding the positrons towards the trapping means through these second stop means.

## Patentansprüche

1. Positronenquelle, wobei diese Quelle Elektronenstrahlerzeugungsmittel (20) und ein Ziel (28), welches eine im Wesentlichen ebene Fläche aufweist, wobei dieses Ziel dafür vorgesehen ist, um auf der im Wesentlichen ebenen Fläche einen Elektronenstrahl unter einem auf die im Wesentlichen ebene Fläche bezogen gemessenen vorbestimmten Einfallswinkel zu empfangen und um die Positronen durch Wechselwirkung mit dem Elektronenstrahl zu erzeugen, umfasst, wobei diese Quelle **dadurch gekennzeichnet ist, dass** der erzeugte Elektronenstrahl kontinuierlich oder quasi-kontinuierlich ist und die Elektronen eine Energie in der Größenordnung von 10MeV haben und die Dicke des Ziels kleiner als 500pm ist und der vorbestimmte Einfallswinkel kleiner als 10° ist.

2. Positronenquelle nach Anspruch 1, in welcher die Dicke des Ziels (28) innerhalb des Intervalls von 10µm bis 100µm liegt und der Einfallswinkel innerhalb des Intervalls von 2° bis 5° liegt.

3. Positronenquelle nach einem der Ansprüche 1 und 2, in welcher die Elektronenstrahlerzeugungsmittel einen kontinuierlichen Strahl erzeugen und einen Elektronenbeschleuniger (20) umfassen, der einen koaxiale Hohlraumresonator umfasst, den die Elektronen mehrmals in einer zur Achse dieses Hohlraums senkrechten Mittelebene durchqueren.

4. Positronenquelle nach einem oder mehreren der Ansprüche 1 bis 3, die ferner Mittel zum Trennen der Positronen und der Elektronen, die nicht mit dem Ziel in Wechselwirkung getreten sind, aufweist, umfassend:
- erste Magnetmittel (26), deren Achse derjenigen des Strahles benachbart ist und die durch die Ebene des Zieles verläuft, vorgesehen zum Erzeugen eines zum Ablenken der von dem Ziel emittierten Positronen geeigneten Magnetfeldes, wobei die ersten Magnetmittel dem Ziel in einem geeigneten Abstand vorgelagert sind,
- ein magnetischer Quadrupol (30) zur Bündelung des Positronenstrahls, mit der gleichen Achse, wie die ersten Magnetmittel, das dem Ziel nachgelagert ist und dazu vorgesehen ist, den Querschnitt des Positronenstrahls, der am Ausgang der Zone der Wechselwirkung zwischen den Elektronen und dem Ziel sehr abgeflacht ist, kreisförmig zu machen,
- erste Einfangmittel (32), die sich, dem Quadrupol vorgelagert, auf der Achse der ersten Magnetmittel, in einem hinreichenden Abstand zur Bündelung der Positronen in einem Strahl kreisförmigen Querschnittes befinden und die vorgesehen sind, um diejenigen Elektronen des Elektronenstrahls einzufangen, die nicht mit dem Ziel in Wechselwirkung getreten sind,
- zweite Magnetmittel (36), mit gleicher Achse, wie die ersten Magnetmittel, die den ersten Einfangmitteln in einem geeigneten Abstand von den ersten Magnetmitteln vorgelagert sind, um ein Magnetfeld zu erzeugen, das dazu geeignet ist, die Positronen zu bündeln, wobei die ersten und zweiten Mittel zum Erzeugen eines Magnetfeldes zusammenwirken, das geeignet ist, diese Positronen daran zu hindern, auf die ersten Einfangmitteln zu treffen.

5. Positronenquelle nach einem der Ansprüche 1 bis 4, ferner umfassend:
- Fallenmittel (46), vorgesehen zum Einfangen der von dem Ziel erzeugten Positronen
- Führungsmittel (42), vorgesehen zum führen der Positronen in Richtung der Fallenmittel.

6. Positronenquelle nach Anspruch 5, wobei die Fallenmittel (46) eine Greaves-Surko-Falle umfassen.

7. Positronenquelle nach Anspruch 4 und einem der Ansprüche 5 und 6, ferner umfassend:
- zweite Einfangmittel (38), vorgesehen zum Einfangen der Elektronen des Elektronenstrahls, die nicht mit dem Ziel in Wechselwirkung getreten sind und einen Bereich erreicht haben, der zwischen den zweiten Magnetmitteln und den Fallenmitteln eingeschlossen ist und zum Abhalten dieser Elektronen vom Erreichen dieser Fallenmittel, und
- Führungsmittel (42), die dazu geeignet sind, die Positronen in Richtung der Fallenmittel durch die zweiten Einfangmittel zu führen.
